# EUROPÄISCHE PATENTANMELDUNG

(11) **EP 4 543 169 A1**
(43) Veröffentlichungstag der Anmeldung: **23.04.2025**
(21) Anmeldenummer: 24201117.9
(22) Anmeldetag: 18.09.2024
(51) Int. Cl.: H10H 20/01, H10H 20/851, H10H 20/855, H10H 20/80, H10F 77/40

(54) **LASER-STRUKTURIERTES OPTISCHES ELEMENT**

(30) Priorität: 22.09.2023 DE 102023125725
(71) Anmelder: SCHOTT AG, 55122 Mainz (DE)
(72) Erfinder: SCHULTHEIS, Bernd, 55270 Schwabenheim (DE); GRAF, Christian, 55122 Mainz (DE)
(74) Vertreter: Schott Corporate IP

(57) **Zusammenfassung**

Die Erfindung betrifft eine Beleuchtungs- oder Detektoreinheit (1), umfassend mindestens ein Halbleiterelement (20), welches insbesondere als LED, Laser-Diode oder Detektor ausgebildet ist, wobei das Halbleiterelement (20) Kontaktierungen (22) und/ oder Leiterbahnen (23) auf seiner im Betriebszustand leuchtenden oder signalempfangenden Oberfläche aufweist, wobei, auf dieser leuchtenden oder signalempfangenden Oberfläche des Halbleiterelementes (20) ein optisches Element (30), das ein im Wesentlichen planares oder scheibenförmiges Substrat (31) aufweist, form- und/ oder stoffschlüssig aufgebracht ist und das optische Element (30) zumindest abschnittsweise eine Grabenstruktur und/ oder Durchgangsstruktur (32) aufweist und wobei das optische Element (30) das Halbleiterelement (20) zumindest teil- oder abschnittsweise überdeckt oder komplett abdeckt, und wobei die Grabenstruktur und/ oder Durchgangsstruktur (32) derart ausgebildet ist, dass das Abstrahlverhalten und/ oder die laterale und/ oder Winkel-Empfindlichkeit in Bereichen der Oberfläche des Halbleiterelementes (20) zumindest lokal oder abschnittsweise beeinflusst oder beeinflussbar ist.

## Beschreibung

### Gebiet der Erfindung

Die Erfindung betrifft eine Beleuchtungs- oder Detektoreinheit umfassend mindestens ein Halbleiterelement, welches beispielsweise als LED, Laser-Diode (LD) oder Detektor ausgebildet sein kann und welches Kontaktierungen und/ oder Leiterbahnen auf dessen im Betriebszustand leuchtenden oder signalempfangenden Oberfläche aufweist, und ein optisches Element, welches mit dem Halbleiterelement verbunden ist und diesen zumindest teil- oder abschnittsweise abdeckt beziehungsweise überdeckt.

LED- oder auch Laserdioden-basierte Beleuchtungseinheiten sind vielfach bekannt und kommen in verschiedensten Beleuchtungsanwendungen vor. Derartige Halbleiterelemente weisen nachteilig im Allgemeinen im Betriebszustand eine ungleichmäßige Abstrahlcharakteristik über ihre Gesamtoberfläche, beispielsweise eine lokal unterschiedliche Helligkeit beziehungsweise Leuchtdichte, auf, welche insbesondere durch Leiterbahnen und/ oder Anschluss- beziehungsweise Kontaktierungsbereiche für die Stromzuführung verursacht werden. Ähnliches ist auch bei Detektoren bekannt und äußert sich bei diesen in ungleichmäßiger Empfindlichkeit über deren aktiver Oberfläche.

Vielfach werden zusätzliche Bauelemente oder aufwendige Baugruppen mit oftmals komplexen, aufwendigen Strukturen vorgeschlagen, um diesen Ungleichmäßigkeiten entgegenzuwirken oder diese gezielt zu beeinflussen.

Es sind beispielsweise optische Detektorsysteme bekannt, bei denen die Empfindlichkeit gezielt eingestellt wird. So beschreibt die EP0901608B1 beispielsweise einen optischen Sensor zur Neigungswinkelbestimmung mit einer optischen Strahlungsquelle, ersten und zweiten strahlungsumlenkenden und abbildenden optischen Elementen, einem ortsauflösenden optoelektronischen Detektor und einer im Strahlengang zwischen den ersten und zweiten optischen Elementen angeordneten Neigungsfläche, auf die die Strahlung der Strahlungsquelle fällt und die die Strahlung im nachfolgenden Strahlenverlauf in eine, von der Neigung des Sensors abhängige Richtung lenkt und dadurch neigungsabhängig den Ort des Bildes der Strahlungsquelle auf dem Detektor bestimmt. Dabei ist vorgesehen, dass die optischen Elemente auf oder/ und in einem Grundkörper aus optisch leitendem Material monolithisch integriert sind, wodurch die Strahlung innerhalb des Grundkörpers geführt wird, und dass der Grundkörper Oberflächenbereiche aufweist, aus denen die Strahlung nach den ersten optischen Elementen in Richtung der Neigungsfläche austritt und in die die Strahlung nach ihrer Reflexion an der Neigungsfläche in den Grundkörper wieder eintritt.

Demgegenüber wird gemäß der Erfindung ein Ansatz verfolgt, der die oben genannten Nachteile verhindert beziehungsweise zumindest reduziert.

### Aufgabe der Erfindung

Aufgabe der Erfindung ist es daher eine Beleuchtungs- oder Detektoreinheit bereitzustellen, bei der ein Halbleiterelement mit einem optischen Element versehen wird oder diese miteinander verbunden werden. Im Falle einer Beleuchtungseinheit, wobei das Halbleiterelement beispielsweise eine LED ist, kann so zum Beispiel deren inhomogene Abstrahlung oder inhomogene Leuchtdichte kompensiert und/ oder korrigiert sowie auch eine Intensitätsverteilung oder Richtung der Abstrahlung gezielt manipuliert werden. Im Falle einer Detektoreinheit kann so zum Beispiel die Richtungsempfindlichkeit und/ oder Ortsempfindlichkeit eines Detektors korrigiert und/oder manipuliert und so beispielsweise an eine Messaufgabe, zum Beispiel die Erfassung von Signalen aus vorgegebenen, bestimmtem Raumrichtungen, angepasst werden. Eine weitere Aufgabe der Erfindung besteht in der Bereitstellung eines Verfahrens zur Herstellung eines entsprechenden optischen Elementes und einer Beleuchtungs- oder Detektoreinheit, die ein solches optisches Element umfasst.

### Kurzbeschreibung der Erfindung

Die Aufgabe der Erfindung wird bereits durch den Gegenstand der unabhängigen Ansprüche gelöst. Vorteilhafte Ausgestaltungen und Weiterbildungen sind Gegenstand der abhängigen Ansprüche.

Die Aufgabe wird gelöst, indem auf der im Betriebszustand leuchtenden oder signalempfangenden Oberfläche des Halbleiterelementes oder Halbleiter-Chips ein optisches Element, aufgebaut aus einem im Wesentlichen planaren und/ oder scheibenförmigen Substrat, form- und/ oder stoffschlüssig aufgebracht ist, und das optische Element zumindest abschnittsweise eine Grabenstruktur und/ oder Durchgangs-Struktur beziehungsweise Lochstruktur oder lochartige Struktur, zusammengefasst allgemein auch als Struktur oder Strukturen bezeichnet, aufweist, und das Halbleiterelement im Wesentlichen komplett abdeckt oder zumindest teil- oder abschnittsweise überdeckt, und diese Grabenstruktur und/ oder Durchgangs-Struktur derart ausgeführt ist, dass das Abstrahlverhalten, die Richtung der Abstrahlung und/oder die laterale Empfindlichkeit und/ oder Winkel-Empfindlichkeit des Halbleiterelementes gezielt in bestimmten Bereichen der Oberfläche des Halbleiterelementes zumindest lokal beeinflussbar ist. Vorzugsweise befindet sich das optische Element direkt, im Wesentlichen ohne beziehungsweise mit möglichst geringem Abstand, auf der Oberfläche des Halbleiterelementes beziehungsweise ist auf dieser angebracht oder anbringbar. Derartige Verbindungen können form- und/ oder stoffschlüssig ausgebildet sein. Insbesondere wird hierunter auch verstanden, dass das optische Element mittels eines Mittels zum Verbinden, zum Beispiel einem Klebstoff, form- und/ oder stoffschlüssig mit dem Halbleiterelement beziehungsweise dessen Oberfläche verbunden werden kann. Damit können die Nachteile, wie eingangs beschrieben deutlich reduziert werden.

Mit anderen Worten wird auf ein entsprechendes Halbleiterelement ein mit Graben und/ oder Durchgangsstrukturen versehenes, im Wesentlichen planares, optisches Element aufgebracht und diese bilden gemeinsam eine Beleuchtungs- oder Detektoreinheit. Die Anordnung und Auslegung der Strukturen des optischen Elementes ermöglicht im Falle eines im Betriebszustand lichtemittierenden Bauteils, wie einer LED, beispielsweise dessen gegebenenfalls ungleichmäßige Abstrahlung zu kompensieren oder zu korrigieren und/ oder eine bestimmte Abstrahlcharakteristik einzustellen, zum Beispiel eine gezielte Abstrahlung in bestimmte Raumrichtungen. Im Falle eines Detektors als ein im Betriebszustand lichtempfindliches Halbleiterelement, können so beispielsweise dessen ungleichmäßige, insbesondere lokal ungleichmäßige, Empfindlichkeit kompensiert oder korrigiert oder eine bestimmte Empfindlichkeits-Charakteristik, beispielsweise zur Detektion von Signalen aus bestimmten Raumrichtungen, eingestellt werden beziehungsweise diese ist so einstellbar. Hierbei kann ein Halbleiterelement oder auch Halbleiter-Chip, wie zum Beispiel eine LED, die im Betriebszustand leuchtet, oder ein Detektor bzw. Sensor, der zum Beispiel im Betriebszustand auf diesem bzw. auf dessen Oberfläche empfangene Signale, zum Beispiel eine auftreffende Strahlung, wie Licht zumindest einer Wellenlänge oder eines Wellenlängenbereiches des Lichtspektrums, in zum Beispiel elektrische Signale umwandelt, auch als aktives Halbleiterelement bezeichnet werden. Es liegt so eine Beleuchtungs- oder Detektoreinheit vor, umfassend mindestens ein Halbleiterelement, welches insbesondere als LED, Laser-Diode oder Detektor ausgebildet ist, wobei das Halbleiterelement Kontaktierungen und/ oder Leiterbahnen auf seiner im Betriebszustand leuchtenden oder signalempfangenden Oberfläche aufweist, wobei auf dieser leuchtenden oder signalempfangenden Oberfläche des Halbleiterelementes ein optisches Element, das ein im Wesentlichen planares und/oder scheibenförmiges Substrat aufweist, form- und/ oder stoffschlüssig aufgebracht ist und das optische Element zumindest abschnittsweise eine Grabenstruktur und/ oder Durchgangsstruktur aufweist und wobei das optische Element das Halbleiterelement zumindest teil- oder abschnittsweise überdeckt oder komplett abdeckt, und wobei die Grabenstruktur und/ oder Durchgangsstruktur derart ausgebildet ist, dass das Abstrahlverhalten und/ oder die laterale und/ oder Winkel-Empfindlichkeit in Bereichen der Oberfläche des Halbleiterelementes zumindest lokal oder abschnittsweise beeinflusst oder beeinflussbar ist.

Unter Detektoren werden hierbei neben einzelnen Halbleiterelementen auch beispielsweise Anordnungen von lichtempfindlichen Halbleiterelementen verstanden, wie beispielsweise CCD- oder CMOS-Chips, welche eine Kameraanordnung zur Bildaufnahme darstellen können.

Bevorzugt umfasst das optische Element eine planare und vorwiegend transparente Glasplatte, Quarzglas-Platte, Glaskeramik-Platte oder Kunststoff-Platte oder besteht daraus. Insbesondere Glas- oder Quarzglas-Platten sind als Substratmaterialien hinsichtlich ihrer optischen Eigenschaften besonders geeignet. Vorteilhaft einsetzbare Gläser umfassen dabei insbesondere Borosilikatgläser, zum Beispiel Borofloat^{®}, Mempax^{®} oder D263^{®}, oder auch Gläser eines Kalk-Natron-Glas Typs. Es ist so möglich die thermische Dehnung der zu verbindenden Komponenten aneinander anzupassen, beispielsweise an Silizium als Halbleitermaterial. Die zuvor genannten decken Gläser je nach Typ zum Beispiel einen Bereich von etwa 3*10⁻⁶ K⁻¹ bis ca. 9*10⁻⁶ K⁻¹ ab. Je nach eingesetztem Halbleiterelement kann es außerdem vorteilhaft sein alkalifreie oder zumindest alkaliarme Gläser, insbesondere eines Aluminosilikat-Typs, wie zum Beispiel AF32^{®} einzusetzen, welche sich aufgrund geringen oder keines Akaligehaltes gut zur Anwendung mit oder auf Halbleiterelementen eigenen. Glaskeramiken besitzen zudem die Eigenschaft, dass durch deren geringe thermische Ausdehnung, insbesondere bei solchen Glaskeramiken des Lithium-Alumosilikat-Typs (LAS), thermische Spannung vermieden werden und diese auch gegenüber Glas, aber auch gerade gegenüber Kunststoffen, höhere Temperaturbeständigkeit aufweisen. Denkbar sind auch transparente Kunststoffe, wie beispielsweise Polycarbonate (PC) (zum Beispiel MACROLON^{®}), Polymethylmethacrylat (PMMA), Cycloolefin-Copolymere (COC) (zum Beispiel TOPAS^{®}), LSR (Liquid Silicon Rubber) und dergleichen, die sich insbesondere durch eine hohe optische Qualität auszeichnen. Unter transparent im Sinne der Erfindung wird verstanden, dass das optische Element beziehungsweise die Substratmaterialien die es umfasst oder aus denen es besteht in zumindest einem Teilbereich des Spektrums des sichtbaren Lichtes eine Transmission von mehr als 60%, bevorzugt mehr als 80% bei einer Dicke von 1 mm aufweist. Je nach Anwendungsgebiet kann sich dies auch auf andere Wellenlängenbereiche, wie infrarotes oder ultraviolettes Licht beziehen.

Alternativ oder zusätzlich kann beispielsweise zur Unterdrückung von Streulicht oder Verhindern von Übersprecheffekten vorgesehen sein, dass das Substrat des optischen Elementes auch ein transluzentes oder opakes Material umfasst oder daraus besteht. Denkbar ist auch, dass ein Substrat, insbesondere im Bereich des optischen Elementes oder dessen Strukturen, zumindest teil- oder abschnittsweise transluzente oder opake Bereich aufweist, die beispielsweise durch Aufrauen oder Beschichten der Oberfläche des Substrates in diesen Bereichen erhalten werden können. So kann im Falle von Beleuchtungsanwendungen beispielsweise eine Ausleuchtung unerwünschter Bereiche beziehungsweise im Falle von Detektoren beispielsweise eine unerwünschte Vermischung von zu detektierenden Signalen, zum Beispiel aus unterschiedlichen Raumrichtungen, zumindest reduziert werden.

In einer vorteilhaften Ausführungsform der Beleuchtungs- oder Detektoreinheit umfasst das optische Element eine, bevorzugt vorwiegend transparente oder opake, Glasplatte, Quarzglas-Platte, Glaskeramik-Platte oder Kunststoff-Platte oder besteht daraus.

In bestimmten Anwendungsfällen kann das optische Element auch ein Konvertermaterial beziehungsweise Konverter, vorzugsweise ein keramisches Konvertermaterial umfassen oder daraus bestehen, mit dem die spektrale Abstrahlung des Halbleiterelementes beeinflussbar ist. So kann beispielsweise aus blauem Licht einer LED durch Umwandlung mittels eines entsprechenden Konvertermaterials in zum Beispiel gelbes Licht in der Mischung Weißlicht erzeugt werden. Je nach Konvertermaterial lassen sich auch andere Farben außer weiß erzeugen. Derartige keramische Konvertermaterialien beziehungsweise Konversionsmaterialien sind beispielsweise in der WO13060731 A2 oder WO13139619 A1 beschrieben. Diese Materialien weisen insbesondere eine höhere Temperaturbeständigkeit als Kunststoffbasierte Konvertermaterialien auf. Eine zusätzliche Strukturierung, wie es die Erfindung vorsieht, kann insbesondere die Homogenität des konvertierten und/ oder des gemischten Lichtes hinsichtlich Intensitätsverteilung und/ oder Farbverteilung verbessern, wenn es beispielsweise beim Durchtritt des Lichtes durch das Konvertermaterial aufgrund unterschiedlicher Winkel unterschiedlich lange Laufwege gibt, die sich nachteilig auswirken können. Derartige Konvertermaterialien sind in der Regel eher transluzent bis opak und nur in geringen Schichtdicken hinreichend transparent, um Licht in Transmission zu konvertieren und bereitzustellen.

Mit anderen Worten kann das optische Element Materialien umfassen oder daraus bestehen, die es erlauben Licht einer ersten Wellenlänge zumindest teilweise in Licht einer zweiten anderen Wellenlänge umzuwandeln oder zu konvertieren, sogenannte Konverter- oder Konversionsmaterialien. Je nach Anwendung können auch mehrere, in unterschiedliche Wellenlängen konvertierende Materialien eingesetzt werden und so in mehreren Bereichen beispielsweise des sichtbaren Lichtspektrums Licht bereitgestellt werden, so dass unterschiedlich farbiges Licht erhalten werden kann. Bei entsprechender Lichtmischung kann auch weißes Licht generiert werden. Dies ist beispielsweise bei Lichtquellen einer ersten, beispielsweise blauen, Wellenlänge oder Wellenlängenbereichs in Kombination mit zum Beispiel gelbem Licht einer zweiten, Wellenlänge oder Wellenlängenbereichs, eines Konvertermaterials durch entsprechende Mischung des blauen und des konvertierten gelben Lichtes möglich. Vertreter derartiger Konversionsmaterialien ist beispielsweise Cer-dotierter Yttrium-Aluminium-Granat (Ce:YAG), der zum Beispiel entweder in Kunststoffe eingebettet, in eine Glasmatrix gebunden oder als keramisches Material, sogenannte Optokeramiken, vorliegen kann.

In einer vorteilhaften Ausführungsform umfasst das optische Element der Beleuchtungs- oder Detektoreinheit alternativ oder zusätzlich ein Konverter-Material, vorzugsweise ein keramisches Konverter-Material, oder besteht daraus, wobei im Betriebszustand durch das Konverter-Material die spektrale Abstrahlung des Halbleiterelementes beeinflussbar ist.

Somit kann das optische Element ein Konverter-Material umfassen oder daraus bestehen oder auch eine Kombination, zum Beispiel ein Werkstoffverbund, aus einer planaren, vorwiegend transparenten oder opaken Glasplatte, Quarzglas-Platte, Glaskeramik-Platte oder Kunststoff-Platte und einem Konverter-Material umfassen oder daraus bestehen.

Für beispielsweise spektroskopische Anwendungen kann alternativ oder zusätzlich auch vorgesehen sein, dass das optische Element einen optischen Filter in Form einer Filterscheibe oder einer Glas- oder Kunststoffplatte mit einer optischen Filterbeschichtung umfasst oder daraus besteht. Derartige Filter können als Kantenfilter, Verlaufsfilter, Polarisationsfilter oder Interferenzfilter ausgebildet sein, wobei mit einer Strukturierung, wie vorgeschlagen, die Orts- bzw. Winkelempfindlichkeit gezielt einstellbar ist. Ebenso denkbar sind auch sogenannte Bayer-Filter oder Komplementärfarbenfilter, die aufgrund einer Strukturierung pixelabhängig nur bestimmte Spektralbereiche durchlassen.

Das optische Element der Beleuchtungs- oder Detektoreinheit weist vorzugsweise eine Dicke im Bereich von 0,02 bis 2,0 mm, bevorzugt 0,1 bis 1,5 mm, meist bevorzugt 0,5 bis 1,0 mm auf. Seine lateralen Abmessungen liegen vorzugsweise im Bereich von 0,1 × 0,1 mm² bis 10 × 10 mm², wobei es vorteilhaft eine äußere Form aufweist, die an die Form und Abmessungen des Halbleiterelementes angepasst ist und insbesondere quadratisch, rechteckig oder polygonal ausgebildet ist oder sein kann.

Polygonale Formen sind für das optische Element beziehungsweise dessen laterale Ausdehnungen oder Querschnittsfläche insbesondere dann vorteilhaft, wenn zum Beispiel das Halbleiterelement lateral zwar eine beispielsweise quadratische Fläche aufweist, aber zumindest ein Teil dieser Grundfläche passiv ausgebildet ist, beispielsweise eine Ecke quadratisch oder diagonal beziehungsweise dreieckig, beispielsweise als elektrische Kontaktfläche, von der aktiven Fläche, also zum Beispiel der Fläche, die bei einer LED im Betriebszustand leuchtet, ausgespart ist. Grundsätzlich sind für das optische Element zum Beispiel auch runde Geometrien beziehungsweise andere Abmessungen für bestimmte oder spezielle Anwendungen denkbar.

In speziellen Fällen kann die Dicke des optischen Elementes auch > 2,0 mm sein, vorzugsweise von >2,0 mm bis 5 mm sein, insbesondere wenn spezielle optische Effekte bei Beleuchtungsanwendungen erzielt werden sollen, beziehungsweise die laterale und/oder winkelabhängige Empfindlichkeit bei Detektor-Anwendungen noch gesteigert werden soll.

So können vorteilhaft viele Anwendungen mit der Bereitstellung von Beleuchtungs- oder Detektoreinheiten mit derartigen optischen Elementen, die einzelne oder mehrere Halbleiterelemente, also Beleuchtungs- oder Detektorelemente, zumindest teilweise überdecken und deren Charakteristika verbessern, abgedeckt werden.

In einer vorteilhaften Ausführungsform weist die Grabenstruktur des optischen Elements der Beleuchtungs- oder Detektoreinheit zusätzlich oder alternativ eine Tiefe auf, die bis zu 90 % der Dicke des optischen Elements beträgt.

Damit kann, insbesondere auch bei vergleichsweisen dünnen Plättchen, also geringen Dicken des optischen Elementes, eine signifikante Beeinflussung der Intensität und/ oder der Abstrahl- oder Winkelverteilung im Falle von lichtemittierenden Halbleiterelementen oder im Falle von Detektoren eine signifikante Beeinflussung der Empfindlichkeit und/ oder der Einstrahl-Winkelverteilung ermöglicht werden. Dabei können die Tiefen der Gräben zumindest lokal auch unterschiedlich tief eingebracht sein, sich von Graben zu Graben unterscheiden, oder auch innerhalb eines Grabens variieren. Der Begriff Graben steht hierbei allgemein synonym für Strukturen, die von einer Seite in das Substrat des optischen Elementes eingebracht sind, also ausgehend von einer Seite innerhalb des optischen Elementes enden.

In weiteren vorteilhaften Ausführungen kann alternativ oder zusätzlich vorgesehen sein, dass das optische Element der Beleuchtungs- oder Detektoreinheit eine Graben- und/ oder Durchgangsstruktur aufweist, deren Aspektverhältnis von maximaler Tiefe, welche bei Durchgangsstrukturen der Dicke des optischen Elementes entspricht, zur minimalen Strukturbreite, zumindest lokal oder abschnittsweise einen Wert von bis zu 200:1 aufweist.

Somit umfasst oder hat das optische Element also beispielsweise eine Graben- und/ oder Durchgangsstruktur, die zumindest lokal oder abschnittsweise bei einer Tiefe von 2 mm eine minimale Strukturbreite von 10µm beziehungsweise bei einer Tiefe oder Dicke von 1 mm entsprechend von 5 µm aufweist. In speziellen Fällen können auch derartige Aspektverhältnisse zumindest lokal oder abschnittsweise von bis zu 600:1 notwendig sein beziehungsweise erreicht werden, zum Beispiel bei einer zumindest lokal oder abschnittsweise minimalen Grabenreite von circa 3 µm entsprechend dann einer Tiefe von circa 1,8 mm.

So kann gezielt und/ oder anforderungsgerecht die Wirksamkeit der Anpassung oder Modifikation der Beleuchtungs- oder Detektoreinheit beispielsweise der Abstrahlcharakteristik einer LED beziehungsweise die Empfindlichkeitscharakteristik eines Detektors mittels eines entsprechend angepassten optischen Elementes beeinflusst beziehungsweise eingestellt werden.

In vorteilhaften Weiterbildungen der Beleuchtungs- oder Detektoreinheit sind zusätzlich oder alternativ die Querschnittsflächen der Grabenstruktur und/oder Durchgangsstruktur rund, unrund und/oder im Wesentlichen polygonal, insbesondere rechteckig oder quadratisch oder als eine Kombination daraus ausgebildet.

Unter Querschnittsflächen werden dabei die Flächen der Graben- und/ oder Durchgangsstrukturen verstanden, die in einer Aufsicht auf das optische Element vorliegen oder erkennbar sind. Diese Querschnittsflächen können insbesondere in deren Randbereichen beziehungsweise deren Ecken und/oder deren Kanten, prozessbedingte Verrundungen aufweisen. Auch können die Querschnittsflächen an deren Enden rundlich, beispielsweise rechteckig mit im wesentlichen runden Enden, insbesondere auch als Langlöcher beziehungsweise langestreckte Sacklöcher, ausgebildet sein. Dabei kann ein optisches Element unterschiedliche der vorgenannten Querschnittsflächen aufweisen, also beispielsweise gleichzeitig runde Durchgangstrukturen und im Wesentlichen rechteckige Gräben umfassen. Grabenstrukturen können, wie zuvor bereits beschrieben, in einem optischen Element auch unterschiedlich tief ausgebildet vorliegen und dabei können die Grabenstrukturen in deren Tiefe oder an oder um deren Boden ebenfalls Verrundungen aufweisen oder rundlich ausgebildet sein.

Mithin können so die Strukturen, welche als Durchgangs-Strukturen, also Öffnungen durch das Substrat, ausgelegt sind, beispielsweise als runde Löcher, langgestreckte Löcher oder Langlöcher und/ oder als sonstige geometrische Formen, auch als Bogen oder Kreissegment oder Kurve, ausgebildet beziehungsweise durch diese begrenzt sein. Für die Strukturen, welche als Grabenstrukturen, also einseitige Öffnungen im Substrat, ausgelegt sind, können diese demnach beispielsweise als runde Sacklöcher, Langlöcher und/ oder als sonstige geometrische Formen, auch als Bogen oder Kreissegment oder Kurve, ausgebildet beziehungsweise durch diese begrenzt sein.

In einer weiteren vorteilhaften Ausführungsform ist alternativ oder zusätzlich die Grabenstruktur und/ oder Durchgangsstruktur des optischen Elementes der Beleuchtungs- oder Detektoreinheit zumindest abschnittsweise gegenüber der Flächennormalen des optischen Elementes im Bereich von 1° bis 45°, bevorzugt 1° bis 25°, meist bevorzugt 5° bis 10° geneigt ausgebildet.

So kann vorteilhaft die Abstrahlcharakteristik beispielsweise einer LED beziehungsweise die Empfindlichkeitsanpassung eines Detektors noch weiter verstärkt, ausgeprägt beziehungsweise eingestellt werden.

Der Neigungswinkel der Strukturen kann dabei beispielsweise über die gesamte Fläche des optischen Elementes mit gleichem Neigungswinkel ausgebildet sein oder auch unterschiedliche Neigungswinkel aufweisen, zum Beispiel abhängig vom Abstand zum Flächen-Mittelpunkt des optischen Elementes einen zunehmenden oder abnehmenden Neigungswinkel. Damit können insbesondere bei Beleuchtungseinrichtungen unter anderem Fokussier-Effekte oder auch Aufweitungen des das optische Element durchtretenden Lichtkegels erzielt werden.

Mit anderen Worten liegt damit ein optisches Element vor, bei dem die Strukturen zumindest teil- oder abschnittsweise gegenüber der Flächennormalen geneigt eingebracht ausgebildet sind. Zumindest teil- oder abschnittsweise können die Neigungswinkel auch unterschiedlich ausgebildet sein. Alternativ oder zusätzlich können die Neigungswinkel auch zumindest teil- oder abschnittsweise so ausgelegt werden, dass diese sich ausgehend von einem Zentrum oder einer Symmetrielinie, gegebenenfalls regelmäßig, derart ändern, dass diese auf einen gedachten Punkt oder eine gedachte Linie außerhalb des optischen Elementes zusammenlaufen. Damit kann zum Beispiel im Falle eines lichtemittierenden Halbleiterelementes, beispielsweise einer LED, eine Abstrahlung des im Betriebszustand emittierten Lichtes in mehrere, unterschiedliche Raumrichtungen ausgerichtet werden beziehungsweise im Falle einer Detektoreinrichtung die Raumrichtungen der Einstrahlung auf den Detektor eingestellt werden.

In einer Weiterbildung der Erfindung kann alternativ oder zusätzlich vorgesehen sein, dass das optische Element der Beleuchtungs- oder Detektoreinheit eine Grabenstruktur und/ oder Durchgangsstruktur aufweist, welche zumindest teilweise mit lichtabsorbierendem Material gefüllt ist und/ oder die Seitenflächen der Strukturen zumindest teilweise absorbierend oder reflektierend beschichtet sind. Damit können beispielsweise Streulichteffekte, wie die Abstrahlung von Licht einer LED in bestimmte, unerwünschte Raumrichtungen, oder Übersprechen von Signalen beziehungsweise zu detektierender Strahlung aus unerwünschten oder bestimmten Raumrichtungen bei Detektoren minimiert werden. Gerade bei Detektoren kann die absorbierende beziehungsweise reflektierende Füllung oder Beschichtung auch für Wellenlängenbereiche abseits eines Lichtspektrums, also sichtbarem (VIS), infrarotem (IR) oder ultravioletten (UV) Lichtes ausgelegt sein, falls länger- oder kürzerwellige Strahlung detektiert werden soll. Ähnliches kann auch auf eine Beleuchtungseinrichtung zutreffen, insofern deren Quelle länger- oder kürzerwellige Strahlung als beispielsweise sichtbares (VIS), infrarotes (IR) oder ultraviolettes (UV) Licht emittiert.

In weiter bevorzugten Ausführungsformen sind alternativ oder zusätzlich die Graben- und/ oder Durchgangs-Struktur des optischen Elementes der Beleuchtungs- oder Detektoreinheit insbesondere über Bereiche des Halbleiterelementes angeordnet, in denen Kontaktierungen und/ oder Leiterbahnen angeordnet sind. Damit lassen sich die eingangs beschriebenen störenden Effekte, wie beispielsweise ungleichmäßige oder inhomogene Abstrahlung einer LED, die insbesondere in den Bereichen der gegebenenfalls zwar erforderlichen, aber eben störenden Kontaktierungen und/ oder Leiterbahnen des Halbleiterelementes auftreten, beseitigen beziehungsweise zumindest teilweise kompensieren.

Eine besonders bevorzugte Ausführungsform sieht alternativ oder zusätzlich vor, dass das optische Element der Beleuchtungs- oder Detektoreinheit zumindest abschnittsweise weitere Strukturen aufweist, die das Halbleiterelement im Wesentlichen formschlüssig umgeben. Zum einen dient dies der Stabilität der Verbindung zwischen Halbleiterelement und optischem Element und zum anderen der definierten Positionierung, Ausrichtung und/ oder Justage des optischen Elementes auf dem Halbleiterelement.

Es liegt so also ein optisches Element vor, das zum einen Graben- und/ oder Durchgangsstrukturen aufweist, die insbesondere Lichtabgabe bei einer Beleuchtungseinrichtung, oder Signalaufnahme bei einer Detektoreinrichtung beeinflussen und welches zum anderen alternativ oder zusätzlich derart ausgebildet ist, dass dies zumindest teilweise größer als das zu überdeckende Halbleiterelement ausgebildet ist und dieses mittels einer oder mehrerer, dem Halbleiterelement zugewandten, weiterer Strukturen formschlüssig umgibt beziehungsweise umschließt.

Diese weiteren Strukturen des optischen Elementes können dabei das Halbleiterelement zumindest teil- oder abschnittsweise umschließen, beispielsweise mittels zumindest zwei Stegen an den Kanten des Halbleiterelementes oder mittels zumindest zwei weiterer, quasi eckiger, Strukturen oder Eckstrukturen, die das Halbleiterelement an eventuell daran vorhandenen Ecken formschlüssig umgeben. Insbesondere umgeben die weiteren Strukturen das Halbleiterelement vollständig. Die weitere Struktur ist in diesem Falle also als Ausnehmung im optischen Element auf der dem Halbleiterelement zugewandten Seite vorgesehen und entspricht oder folgt im Wesentlichen der lateralen Fläche des Halbleiterelements in Geometrie und lateralen Abmessungen, wobei die lateralen Abmessung der Ausnehmung natürlich so zu wählen sind, dass diese das Halbleiterelement umfassen können. Ähnliches ist auch bei Lage beziehungsweise lateralen Abstand der weiteren Strukturen zu berücksichtigen, die das Halbleiterelement gegebenenfalls nur teil- oder abschnittsweise umfassen. Die äußere laterale Geometrie des optischen Elements kann dabei von der Form des Halbleiterelementes abweichen, die weiteren Strukturen, also die Ausnehmung, eckigen Strukturen oder Stege folgen allerdings der Geometrie beziehungsweise Querschnittsfläche und Abmessungen des Halbleiterelementes.

Eine bevorzugte Verwendung der Beleuchtungs- oder Detektoreinheit mit den zuvor beschriebenen Merkmalen sieht den Einsatz für endoskopische und/ oder spektroskopische Anwendungen im Bereich Medizin- und Industrietechnik vor. Insbesondere bei endoskopischen Anwendungen mit Chip-on-Tip-Technologie, bei denen zum Beispiel LEDn direkt am oder im distalen Ende des Endoskops vorgesehen sind, kann damit erreicht werden, dass zum Beispiel die Lichtverteilung, Ausrichtung und/ oder die Farbverteilung am distalen Ende des Endoskops eingestellt und einer notwendigen oder gewünschten Beleuchtungssituation entsprechend angepasst werden kann.

Eine spektroskopische Anwendung kann z.B. eine RAMAN-Spektroskopische Anwendung sein, bei der intensives Licht einer bestimmten Wellenlänge, üblich sind z.B. 800 nm, scharf gebündelt auf das zu untersuchende Gewebe fokussiert wird und das vom Gewebe rückgestreute Licht typischerweise im Wellenlängenbereich von > 802 nm bis 850 nm, welches eine ggü. dem Anregungslicht nur sehr geringe Intensität hat, in einem Spektrometer analysiert wird und anhand der Signale auf einen Gewebezustand bzw. auf eine Gewebeänderung geschlossen werden kann. Dazu sind entsprechend strukturierte Filterscheiben hilfreich, mit denen einerseits das anregende Licht stark gedämpft werden kann, so dass nur das rückgestreute Licht detektierbar ist, und anderseits durch die Strukturierung, wie zuvor beschrieben, die Winkelabhängigkeit definiert einstellbar ist.

Weitere Verwendungen oder Anwendungen betreffen den Einsatz in, insbesondere adaptiven, Laser- oder LED-Scheinwerfern und/oder LIDAR-Anwendungen, insbesondere im Bereich Automotive. Hier sind insbesondere definierte Abstrahlcharakteristika beziehungsweise definierte Winkelempfindlichkeiten von Interesse.

Ebenso sind vorteilhaft weitere Verwendungen oder Anwendungen für nautische Positionslichter mit definierter Abstrahlcharakteristik, blendfreie Tunnelbeleuchtungen oder einstellbare Leuchten ohne mechanische Verstelleinrichtungen möglich. Derartige Leuchten sind unter anderem als Leseleuchten im Bereich Aviation bekannt und beispielsweise in den Schriften US10,813,185B2 und DE102021104700A1 der Anmelderin beschrieben, bei denen eine Änderung des Abstrahlwinkels durch entsprechende Ansteuerung von LED-Gruppen erfolgt, die gegebenenfalls jeweils mit unterschiedlichem Winkel auf der Leiterplatte (PCB) montiert sind und/ oder mit Linsen oder Lichtleitkegel in unterschiedlichem Winkel positioniert versehen sind. Dies ist im Allgemeinen recht aufwendig. Daher können LEDn mit solchen planaren optischen Elementen kostengünstiger zum Einsatz kommen.

Das erfindungsgemäße Verfahren zur Herstellung einer Beleuchtungs- oder Detektoreinheit, wie sie zuvor beschrieben wurde, sieht vor, dass das optische Element, welches aus einem Substrat aufgebaut beziehungsweise in dieses eingebracht wird, auf das Halbleiterelement aufgebracht wird, wobei die Herstellung des optischen Elementes im Wesentlichen einen planaren Laser-Ätz-Prozess des optischen Elements, einen Fügeprozess des optischen Elementes auf das Halbleiterelement und gegebenenfalls einen Vereinzelungsprozess umfasst.

Das Verfahren zur Herstellung einer Beleuchtungs- oder Detektoreinheit, umfassend mindestens ein Halbleiterelement, welches insbesondere als LED, Laser-Diode oder Detektor ausgebildet ist und welches Kontaktierungen und/ oder Leiterbahnen auf seiner im Betriebszustand leuchtenden oder signalempfangenden Oberfläche aufweist, und zumindest ein optisches Element, umfasst zumindest die folgenden Schritte:
a. Bereitstellen eines Substrates, bevorzugt in Form eines planaren Substrates, beispielsweise einer Platte eines Borosilikatglases,
b. Strukturieren des Substrates, so dass dies eine Graben- und/ oder Durchgangsstruktur aufweist beziehungsweise diese erhalten wird und somit das zumindest eine optische Element bildet. Das Strukturieren erfolgt bevorzugt mittels eines Laser-Ätzprozesses,
c. Aufbringen des zumindest einen optischen Elementes auf das zumindest eine Halbleiterelement, so dass diese form- und/ oder stoffschlüssig verbunden sind.

In Schritt a. kann ein einzelnes Substrat bereitgestellt werden, welches in Schritt b. strukturiert wird, so dass ein optisches Element erhalten wird, und dieses anschließend in Schritt c. auf ein Halbleiterelement aufgebracht wird. Das Halbleiterelement kann sich dabei auch auf einer weiteren Trägerplatte oder Platine oder noch auf einem Halbleiterwafer, gegebenenfalls zusammen mit anderen oder weiteren Bauelementen, befinden. Es können in Schritt b. auch mehrere optische Elemente auf einem Substrat realisiert werden, die gemeinsam oder vereinzelt auf mehrere Halbleiterelemente aufgebracht werden können. Das Substrat ist dann in Schritt a. demgemäß in seiner Größe passend, beispielsweise als Substratwafer, auszulegen und die Strukturierung der mehreren optischen Elementes entsprechend vorzusehen. Die Strukturierung beziehungsweise die Strukturen des optischen Elementes können dabei für jedes der Halbleiterelemente, dem diese zugeordnet werden sollen, individuell ausgebildet sein, wobei die Halbleiterelemente sowohl Beleuchtungseinrichtungen oder Lichtquellen, zum Beispiel LEDn, als auch Detektoren oder auch nur ein Typ Halbleiterelemente sein können. So können die zuvor genannten Schritte, insbesondere Schritt c., auch auf mehrere Halbleiterelemente, die sich beispielsweise auf einer gemeinsamen Platine beziehungsweise Träger oder gemeinsam auf einem Wafer befinden angewendet werden.

Das Substrat umfasst demnach alternativ oder zusätzlich gegebenenfalls mehr als ein optisches Element beziehungsweise es können durch die Strukturierung mit einer Graben- und/oder Durchgangsstruktur mehrere optische Elemente in oder auf einem Substrat erhalten, ausgebildet beziehungsweise eingebracht sein.

Beim einem Laser-Ätz-Prozess, als bevorzugtes Verfahren in Schritt b., werden zunächst mit einem Laser, insbesondere einem Kurzpuls-Laser oder Ultrakurzpuls-Laser mikroskopische Schädigungen in das Substrat, zum Beispiel in eine Borosilikat-Platte, eingebracht. Anschließend werden mittels nasschemischer Ätzverfahren, beispielsweise mit oder in sauren oder basischen Lösungen beziehungsweise Ätzmitteln, diese Schädigungen zu den gewünschten Graben- und/ oder Durchgangsstrukturen geätzt beziehungsweise entwickelt und so ein oder mehrere optische Elemente erhalten werden. Derartige Laser-Ätz-Prozesse sind unter anderem in den Schriften WO 2022/078774 A1 und EP3984970 A1 der Anmelderin beispielhaft beschrieben. Insbesondere in der Halbleitertechnik üblich sind auch sogenannte Trockenätzverfahren, die auch hier zum Einsatz kommen können, wie zum Beispiel das Ionen-unterstützte reaktive Plasma-Ätzen (zum Beispiel RIE - reactive ion beam etching), ein anisotropes Ätzverfahren bei sehr geringem Druck (beispielsweise unterhalb 10 mbar), welches insbesondere sehr schmale und tiefe Strukturen mit hohem Aspektverhältnis als Verhältnis von Ätztiefe zur typischen Strukturbreite zulässt. Nasschemische Ätzverfahren mit Säuren oder auch Laugen sowie Plasma-Ätzverfahren mit höheren Prozessdrücken (beispielsweise oberhalb 10 mbar) sind dagegen als isotrope Ätzverfahren bekannt.

Der Füge- oder Verbindungsprozess nach Schritt c. geschieht beispielsweise mittels, vorzugsweise transparenten, Epoxyd-Kleber oder Silikon-Kleber als Fügematerial oder Mittel zum Verbinden, wobei je nach den Elastizitätseigenschaften des Fügematerials auch Materialien mit sehr unterschiedlichen thermischen Ausdehnungskoeffizienten verbunden werden können, zum Beispiel als Konverter ausgebildete optische Elemente auf Halbleiterelemente. Möglich sind auch Fügeprozesse mit anorganischen, insbesondere nichtmetallischen, Mitteln zum Fügen, wie Sol-Gel-Lösungen oder Glaslote. Vorteilhaft sind die Fügematerialien transparent, insbesondere bei relevanten Wellenlängen beziehungsweise im relevanten Wellenlängenbereich der Anwendung, beispielsweise im sichtbaren Spektrum des Lichts im Falle der Anwendung mit oder auf einer LED, die zusammen mit einem Konverter weißes oder farbiges sichtbares Licht bereitstellen soll. Weiter vorteilhaft sind die Fügematerialien hinsichtlich deren Brechzahl an Substrat und/ oder Halbleiterelement weitgehend oder insoweit möglich angepasst.

In einer vorteilhaften Weiterbildung des Verfahrens wird in Schritt a. ein Substrat, beispielsweise ein Substrat-Wafer, bereitgestellt und in Schritt b. wird das Substrat mit einer Mehr- oder Vielzahl Graben- und/oder Durchgangsstrukturen versehen, die so eine Mehr- oder Vielzahl optischer Elemente bilden und in Schritt c. das Substrat mit der Mehr- oder Vielzahl optischer Elemente mit einem Halbleiter-Wafer, Platine oder Träger mit einer Mehr- oder Vielzahl von Halbleiterelementen stoff- und/oder formschlüssig verbunden wird. Dabei weist das Substrat laterale Ausdehnungen auf, die den Halbleiter-Wafer oder den Träger zumindest teil- oder abschnittsweise überdecken. Dabei wird je ein optisches Element je einem Halbleiterelement zugeordnet beziehungsweise ist diesem zuordenbar und das optisches Element überdeckt das Halbleiterelement zumindest teil- oder abschnittsweise. Der Halbleiter-Wafer oder der Träger wird anschließend zusammen mit dem Substrat vereinzelt, so dass eine Mehr- oder Vielzahl von Beleuchtungs- oder Detektoreinheiten vorliegt.

Der Begriff des Wafers, Substrat-Wafers oder auch eine entsprechende Platte ist dabei nicht auf runde Geometrien beschränkt, vielmehr ist dieser hinsichtlich seiner lateralen Ausdehnungen oder Geometrie für die Anwendung auszulegen bzw. auch vorgegeben und kann insbesondere auch rechteckig, quadratisch oder polygonal ausgebildet sein. Es ist dabei besonders vorteilhaft, wenn mehrere optische Elemente als eine Einheit dem Laser-Ätz-Prozess in einem Schritt auf oder in einem Substrat hergestellt werden, diese Einheit dann auf einen Wafer mit den Halbleiterelementen aufgebracht und mit diesem form- und/oder stoffschlüssig verbunden werden und anschließend der Verbund aus Substratwafer mit den optischen Elementen und Halbleiterwafer zu je einem Halbleiterelement zusammen mit einem optischen Element, vereinzelt werden. Damit lassen sich eine Vielzahl, gegebenenfalls gleichartiger, Bauteile, also der Beleuchtungs- oder Detektoreinheiten, in Batches verarbeiten beziehungsweise erhalten, was insbesondere Kosten senkt. Demgemäß wird in Schritt a. ein Substrat beispielsweise entsprechend der Größe des Halbleiter-Wafers mit den Halbleiterelementen oder des Bereiches des Wafers, der überdeckt werden soll, bereitgestellt und in Schritt b. die gewünschte Strukturierung vorgenommen, also eine Mehr- oder Vielzahl optischer Elemente beziehungsweise deren Strukturen in das Substrat eingebracht, so dass eine Mehr- oder Vielzahl optischer Elemente in oder auf dem Substrat vorliegt, und in Schritt c. kann das das strukturierte Substrat mit der Mehr- oder Vielzahl von optischen Elementen auf den Halbleiter-Wafer appliziert und mit diesem verbunden werden. Anschließend kann der Halbleiterwafer mit dem darauf aufgebrachten Substrat mit der Mehr- oder Vielzahl optischer Elemente, die die einzelnen Halbleiterelemente auf dem Wafer zumindest teilweise überdecken, zu Halbleiterelementen mit optischen Elementen vereinzelt werden, so dass dann eine Mehr- oder Vielzahl Beleuchtungs- oder Detektoreinrichtungen erhalten wird. Denkbar ist dabei auch, dass auf dem Wafer sowohl Lichtquellen als auch Detektoren vorliegen, die gegebenenfalls von einem gemeinsamen oder mehreren optischen Elementen überdeckt werden und, dass alternativ oder zusätzlich den Halbleiterelementen unterschiedliche strukturierte optische Elemente zugeordnet sind. Mit anderen Worten es können so individuell unterschiedliche Beleuchtungs- oder Detektoreinrichtungen bereitgestellt werden. Insbesondere vorteilhaft hinsichtlich kostengünstiger Herstellung ist es, wenn viele oder ausschließlich gleiche Einrichtungen, das heißt beispielsweise gleiche Halbleiterelemente mit identischen optischen Elementen, hergestellt werden.

Eine weitere vorteilhafte Weiterbildung des Verfahrens sieht alternativ oder zusätzlich vor, dass in Schritt a. ein Substrat, beispielsweise ein oder als Substrat-Wafer bereitgestellt wird und in Schritt b. das Substrat mit einer Mehr- oder Vielzahl Graben- und/oder Durchgangsstrukturen versehen wird, die eine Mehr- oder Vielzahl optischer Elemente bilden und vor dem Schritt c. das Substrat mit der Mehr oder Vielzahl optischer Elemente vereinzelt wird, so dass eine Mehr- oder Vielzahl vereinzelter optischer Elemente vorliegt und in Schritt c. je einem Halbleiterelement ein optisches Element zugeordnet wird beziehungsweise zuordenbar ist und das optische Element und das Halbleiterelement stoff- und/ oder formschlüssig miteinander verbunden werden, wobei das optische Element das Halbleiterelement zumindest teil- oder abschnittsweise überdeckt, so dass eine Mehr- oder Vielzahl von Beleuchtungs- oder Detektoreinheiten vorliegt.

Es werden so also mehrere optische Elemente in oder auf einem Substrat beziehungsweise einem Substratwafer als eine Einheit dem Laser-Ätz-Prozess unterzogen und so hergestellt. Diese werden dann aus dem Substrat vereinzelt und anschließend auf bereits zuvor vereinzelte Halbleiterelemente oder einzeln vorliegende Halbleiterelemente, die gegebenenfalls auch auf einem Träger oder Platine aufgebracht beziehungsweise angeordnet sein können, aufgebracht und stoff- und/ oder formschlüssig mit diesen verbunden. Dieses Verfahren kann bei kleineren Mengen oder bei komplexen Geometrien von Halbleiterelementen und/ oder optischen Elementen zum Einsatz kommen.

Damit wird ein in Schritt a. bereitgestelltes Substrat, zum Beispiel ein Substratwafer, in Schritt b. mit einer Vielzahl von Strukturen, also optischen Elementen versehen, die zunächst vereinzelt und dann anschließend in einem Schritt c. auf Halbleiterelemente appliziert werden. Dabei können in Schritt b. sowohl identische als auch unterschiedlich strukturierte optische Elemente hergestellt werden, die dann in Schritt c. mit Halbleiterelementen, gegebenenfalls mit je unterschiedlichen Halbleiterelementen, verbunden werden. Insbesondere vorteilhaft ist es, wenn die lateralen Abmessungen der optischen Elemente beziehungsweise zumindest der zu vereinzelnden Elemente gleich sind, so dass ein regelmäßiger Vereinzelungsprozess zur Anwendung kommen und damit gegebenenfalls anfallender Verschnitt oder unterschiedliche Schnittführung vermieden werden kann. Es können entsprechend dieses Verfahrens auch hier eine Vielzahl Beleuchtungs- oder Detektoreinheiten vorliegen beziehungsweise hergestellt werden, die sowohl identisch sein können, also Halbleiterelemente gleichen Typs, die mit im Wesentlichen gleichen oder ähnlichen optischen Elementen verbunden sind. Es können aber auch verschiedene Beleuchtungs- oder Detektoreinheiten erhalten werden, wenn Halbleiterelemente unterschiedlicher Typen mit je dazu passenden oder dafür vorgesehenen beziehungsweise entworfenen optischen Elementen zusammengebracht werden.

### Figurenbeschreibung

Die Erfindung wird nachfolgend anhand von Figuren näher beschrieben.

Es zeigen:
Figur 1 einen schematischen Aufbau einer Beleuchtungs- beziehungsweise einer Detektoreinheit,
Figur 2a und 2b schematisch je eine Oberfläche eines Halbleiterelementes mit Leiterbahnen beziehungsweise Kontaktierungsbereichen und
Figur 3 schematisch einen Kanteneffekt bei LEDn.

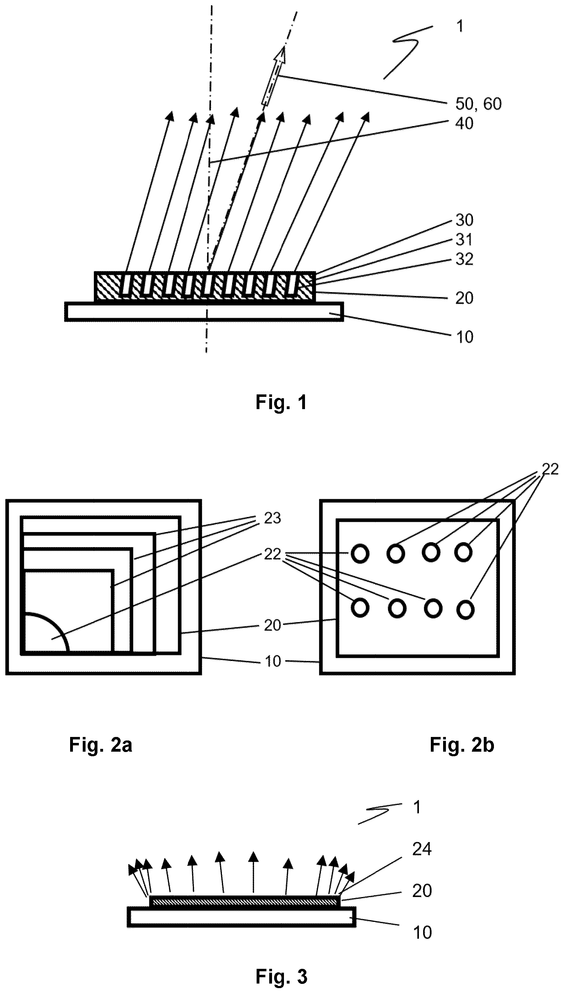

Figur 1 zeigt schematisch in einer Schnittdarstellung den Aufbau einer Beleuchtungsbeziehungsweise Detektoreinheit 1 gemäß der Erfindung.

Ein Halbleiterelement, aktives Halbleiterelement beziehungsweise Halbleiter-Chip 20, welches beispielsweise ein LED-Chip oder eine Laserdiode, die im Betriebszustand Licht emittieren, oder auch ein Detektor, der im Betriebszustand beispielsweise Licht in ein elektrisches Signal umwandelt, sein kann, ist auf einem Träger 10 aufgebracht. Solche Träger 10 können aus Keramik, aus Metall oder auch als Leiterplatte (PCB) beziehungsweise Platine ausgeführt sein. Metallische Träger 10 dienen insbesondere als Wärmesenke beim Betrieb einer LED oder Laser-Diode bei erhöhten Leistungen, so dass diese hinreichend gekühlt werden können. Auf dem Träger 10 können sich auch noch weitere Bauelemente, oder Baugruppen, und/ oder weitere Halbleiterelemente befinden. Der Träger 10 kann auch als Wafer, insbesondere Halbleiterwafer ausgebildet sein oder als solcher vorliegen, auf dem sich eine Mehrzahl von Halbleiterelementen befindet.

Erfindungsgemäß ist vorgesehen, dass auf dem Halbleiterelement 20 ein optisches Element 30 aufgebracht ist, welches das Halbleiterelement 20 an seinen Rändern zumindest bereichsweise umgibt. Das optische Element 30 besteht aus einem vorwiegend transparenten Substrat 31, in das mittels zum Beispiel eines Laser-Ätzprozesses eine Loch- und/ oder Grabenstruktur 32 eingebracht wird, wodurch das ausgehende Licht des Halbleiterelementes 20, also im Falle beispielsweise einer LED, wie hier beispielhaft dargestellt, gezielt hinsichtlich der Abstrahlrichtung beziehungsweise seiner lateralen Abstrahlintensität einstellbar ist. Die Lochbeziehungsweise Durchgangs- oder Grabenstruktur 32 kann dabei gegenüber der planaren Oberfläche des Halbleiter-Elementes zumindest eine abschnittsweise Schrägstellung beziehungsweise einen Neigungswinkel gegenüber der Flächennormalen 40 aufweisen, um beispielsweise das Licht gegenüber der Flächennormalen 40 des Halbleiter-Elementes in eine dazu schräg verlaufende Abstrahlrichtung 50 zu leiten. Der Neigungswinkel kann dabei typischerweise bis 10° betragen, wobei dies je nach Anwendung gegebenenfalls auch mehr sein kann oder an die Anwendung angepasst werden kann beziehungsweise anpassbar ist.

Für den Fall, dass das Halbleiterelement 20 als Sensor- beziehungsweise Detektorelement ausgeführt ist, kann mit dieser Strukturierung, also der Graben- und/ oder Durchgangsstruktur, beispielsweise die räumliche Empfindlichkeit des Detektorelementes gezielt eingestellt werden beziehungsweise ist so beeinflussbar. Damit kann so zum Beispiel eine Empfindlichkeitsvorzugsrichtung 60, wobei hier der Übersichtlichkeit halber auf eine Darstellung der Umkehrung der Pfeilrichtungen in Richtung des Halbleiterelementes 20 verzichtet wurde, eingestellt werden. Weiterhin können auch Abschattungsbereiche, um beispielsweise Streulicht auszublenden, realisiert werden. In diesen Fällen kann das Substrat 31 auch aus einem transluzenten oder einem opaken Material bestehen.

In einer weiteren Ausführungsform kann alternativ oder zusätzlich auch vorgesehen sein, dass die Graben- und oder Durchgangsstruktur 32 mit lichtabsorbierendem Material gefüllt oder an deren Seitenflächen zumindest teilweise mit einer lichtabsorbierenden oder licht-reflektierenden Schicht beschichtet sein kann, um gezielt Streulicht oder Übersprechen zumindest zu unterdrücken.

Vorteilhaft ist es, wenn diese optischen Elemente 30 an der zum Halbleiter-Element zugewandten Seite entsprechende weitere Strukturen aufweisen, die das Halbleiter-Element 20 zumindest teil- oder abschnittsweise umgeben und idealerweise einen thermischen Kontakt zum Träger 10 bilden. Damit kann zusätzlich eine Fixierung des bei gleichzeitiger Justage des optischen Elementes auf dem Halbleiterelement erreicht werden.

In einer anderen Ausführungsform kann ein solches optisches Element 30 auch dazu dienen, um Inhomogenitäten eines lichtemittierenden Halbleiterelementes (LED oder LD) zu kompensieren. Derartige Inhomogenitäten resultieren beispielsweise aus oder an Leiterbahnen 23 und/ oder Kontaktierungsbereichen 22 auf der Halbleiter-Oberfläche beziehungsweise gehen von diesen aus. An Stellen, wo diese Leiterbahnen 23 beziehungsweise Kontaktierungen 22 angeordnet sind, ist zum Beispiel die laterale Abstrahlung der LED oder der Laser-Diode oder auch beispielsweise die Empfindlichkeit eines Detektors zumindest ungleichmäßig beziehungsweise gestört. Solche Leiterbahnen 23 und Kontaktierungsbereiche 22 von Halbleiterelementen 20 sind in den Figuren 2a und 2b schematisch gezeigt.

Figur 3 zeigt schematisch einen Kanteneffekt 24, bei dem es im gezeigten Falle zu einer Erhöhung der Leuchtdichte am Rand von LED-Halbleitern gegenüber dem Mittenbereich kommt (verdeutlicht durch die Dichte der dargestellten Pfeile). Durch eine gezielte Strukturierung des optischen Elementes 30 (hier der Deutlichkeit halber nicht dargestellt) lassen sich solche Effekte ebenfalls weitgehend kompensieren beziehungsweise zumindest reduzieren. Ebenso können Kanteneffekte 24 bei beispielsweise LEDn in geringerer Leuchtdichte an den Kanten resultieren. Auch hier kann durch ein entsprechendes optisches Element 30 korrigierend eingegriffen werden.

Was das Herstellverfahren angeht, ist es besonders vorteilhaft, wenn die Halbleiterelemente 20 gleichermaßen auftretende Inhomogenitäten aufweisen und so auch die optischen Aufsatz-Elemente beziehungsweise optischen Elemente 30 mit den dann im Wesentlichen einheitlichen Strukturen 32 großflächig und damit auch kostengünstig im Batchhergestellt, also als eine Vielzahl optischer Elemente 30 auf beziehungsweise in einem Substrat 31, beispielsweise einem Substratwafer, hergestellt werden können beziehungsweise herstellbar sind und in entsprechender, gegebenenfalls gleicher Orientierung auf die Halbleiterelemente 20 aufgesetzt werden können. Mit anderen Worten kann also eine Vielzahl, zumindest ähnlicher oder ausschließlich gleicher optischer Elemente 30, das heißt diese weisen alle im Wesentlichen die ähnliche oder ausschließlich die gleichen Strukturen 32 auf, in oder auf einem Substrat 30 hergestellt werden. Diese werden dann auf Halbleiterelemente 20 mit im Wesentlichen ähnlichen Unregelmäßigkeiten, wie beispielsweise in der Lichtabgabe im Falle einer LED im Betriebszustand oder in der Empfindlichkeit im Falle eines Detektors im Betriebszustand, appliziert. Hierfür anwendbare Verfahrensvarianten wurden zuvor anhand der Schritte a. bis c. beschrieben, wobei abhängig von der Anwendung auch andere oder weitere Varianten sachdienlich sein können.

### Bezugszeichen

- 1: Beleuchtungs- beziehungsweise Detektoreinheit

- 10: Träger, Platine

- 20: Halbleiterelement, Halbleiter-Chip
- 22: Kontaktierung, Kontaktierungsbereich
- 23: Leiterbahnen
- 24: Kanteneffekt

- 30: Optisches Element
- 31: Substrat
- 32: Graben- und/ oder Durchgangsstruktur

- 40: Flächennormal

- 50: Abstrahlrichtung

- 60: Empfindlichkeitsvorzugsrichtung

## Patentansprüche

1. Beleuchtungs- oder Detektoreinheit (1), umfassend mindestens ein Halbleiterelement (20), welches insbesondere als LED, Laser-Diode oder Detektor ausgebildet ist, wobei
das Halbleiterelement (20) Kontaktierungen (22) und/ oder Leiterbahnen (23) auf seiner im Betriebszustand leuchtenden oder signalempfangenden Oberfläche aufweist, wobei
auf dieser leuchtenden oder signalempfangenden Oberfläche des Halbleiterelementes (20) ein optisches Element (30), das ein im Wesentlichen planares und/ oder scheibenförmiges Substrat (31) aufweist, form- und/ oder stoffschlüssig aufgebracht ist und das optische Element (30) zumindest abschnittsweise eine Grabenstruktur und/ oder Durchgangsstruktur (32) aufweist und wobei
das optische Element (30) das Halbleiterelement (20) zumindest teil- oder abschnittsweise überdeckt oder komplett abdeckt, und wobei
die Grabenstruktur und/ oder Durchgangsstruktur (32) derart ausgebildet ist, dass das Abstrahlverhalten und/ oder die laterale und/ oder Winkel-Empfindlichkeit in Bereichen der Oberfläche des Halbleiterelementes (20) zumindest lokal oder abschnittsweise beeinflusst oder beeinflussbar ist.

2. Beleuchtungs- oder Detektoreinheit (1) nach Anspruch 1, wobei das optische Element (30) eine Glasplatte, Quarzglas-Platte, Glaskeramik-Platte oder Kunststoff-Platte umfasst oder daraus besteht.

3. Beleuchtungs- oder Detektoreinheit (1) nach Anspruch 1 oder 2, wobei das optische Element (30) ein Konverter-Material, vorzugsweise ein keramisches Konverter-Material, umfasst oder daraus besteht, wobei im Betriebszustand durch das Konverter-Material die spektrale Abstrahlung des Halbleiterelementes (20) beeinflussbar ist.

4. Beleuchtungs- oder Detektoreinheit (1) nach Anspruch 1 oder 2, wobei das optische Element (30) einen optischen Filter in Form einer Filterscheibe oder einer Glas- oder Kunststoffplatte mit einer optischen Filterbeschichtung umfasst oder daraus besteht.

5. Beleuchtungs- oder Detektoreinheit (1) nach einem der vorhergehenden Ansprüche, **gekennzeichnet durch** zumindest eines der folgenden Merkmale
- das optische Element (30) weist eine Dicke im Bereich von 0,02 bis 2,0 mm, bevorzugt 0,1 bis 1,5 mm, meist bevorzugt 0,5 bis 1 mm auf,
- das optischen Element (30) weist laterale Abmessungen im Bereich von 0,1 × 0,1 mm² bis 10 × 10 mm² auf,
- das optische Element (30) weist eine äußere Form auf, die angepasst an die Abmessungen oder Geometrie des zumindest einen Halbleiterelementes (20) ist, insbesondere quadratisch, rechteckig oder polygonal ausgebildet ist.

6. Beleuchtungs- oder Detektoreinheit (1) nach einem der vorhergehenden Ansprüche, wobei
die Grabenstruktur eine Tiefe aufweist, die bis zu 90 % der Dicke des optischen Elements (30) beträgt.

7. Beleuchtungs- oder Detektoreinheit (1) nach einem der vorhergehenden Ansprüche, wobei die Graben- und/ oder Durchgangsstruktur (32) ein Aspektverhältnis der maximalen Tiefe der Struktur zur minimalen Strukturbreite aufweist, das zumindest lokal oder abschnittsweise einen Wert von bis zu 200:1 aufweist.

8. Beleuchtungs- oder Detektoreinheit (1) nach einem der vorhergehenden Ansprüche, wobei
die Querschnittsflächen der Grabenstruktur und/oder Durchgangsstruktur (32) rund, unrund und/oder im Wesentlichen polygonal, insbesondere rechteckig oder quadratisch oder als eine Kombination daraus ausgebildet sind.

9. Beleuchtungs- oder Detektoreinheit (1) nach einem der vorhergehenden Ansprüche, wobei
die Grabenstruktur und/ oder Durchgangsstruktur (32) zumindest abschnittsweise gegenüber der Flächennormalen (40) des optischen Elementes im Bereich von 1° bis 45°, bevorzugt 1° bis 25°, meist bevorzugt 5° bis 10° geneigt ausgebildet ist.

10. Beleuchtungs- oder Detektoreinheit (1) nach einem der vorhergehenden Ansprüche, wobei
die Grabenstruktur und/ oder die Durchgangsstruktur (32) zumindest teilweise mit lichtabsorbierendem Material gefüllt ist und/ oder wobei die Seitenflächen der Grabenstruktur und/oder der Durchgangsstruktur (32) zumindest teilweise absorbierend und/ oder reflektierend beschichtet sind.

11. Beleuchtungs- oder Detektoreinheit (1) nach einem der vorhergehenden Ansprüche, wobei
die Grabenstruktur und/ oder Durchgangs-Struktur (32) insbesondere über Bereichen des Halbleiterelementes (20) angeordnet sind, in denen Kontaktierungen (22) und/ oder Leiterbahnen (23) angeordnet sind.

12. Beleuchtungs- oder Detektoreinheit (1) nach einem der vorhergehenden Ansprüche, wobei
das optische Element (30) zumindest abschnittsweise weitere Strukturen aufweist, die das Halbleiterelement (20) im Wesentlichen formschlüssig umgeben.

13. Verwendung der Beleuchtungs- oder Detektoreinheit (1) mit den Merkmalen nach einem der vorhergehenden Ansprüche für endoskopische und/ oder spektroskopische Anwendungen im Bereich Medizin- und Industrietechnik, für, insbesondere adaptive, Laser- beziehungsweise LED-Scheinwerfer insbesondere im Bereich Automotive, für LIDAR-Anwendungen insbesondere im Bereich Automotive, für nautische Positionslichter mit definierter Abstrahlcharakteristik, blendfreie Tunnelbeleuchtungen oder einstellbare Leuchten ohne mechanische Verstelleinrichtungen.

14. Verfahren zur Herstellung einer Beleuchtungs- oder Detektoreinheit (1), umfassend mindestens ein Halbleiterelement (20), welches insbesondere als LED, Laser-Diode oder Detektor ausgebildet ist, wobei das Halbleiterelement (20) Kontaktierungen (22) und/ oder Leiterbahnen (23) auf seiner im Betriebszustand leuchtenden oder signalempfangenden Oberfläche aufweist, und zumindest ein optisches Element (30),
umfassend zumindest die folgenden Schritte
a. Bereitstellen eines Substrates (31) bevorzugt in Form eines planaren Substrates,
b. Strukturieren des Substrates (31), so dass das Substrat eine Graben- und/oder Durchgangsstruktur (32) aufweist und das zumindest eine optische Element (30) bildet, wobei das Substrat (31) bevorzugt mittels eines Laser-Ätz-Prozesses strukturiert wird,
c. Aufbringen des zumindest einen optischen Elementes (30) auf das zumindest eine Halbleiterelement (20), so dass diese stoff- und/oder formschlüssig verbunden sind.

15. Verfahren nach Anspruch 13, wobei
in Schritt a. ein Substrat (31) bereitgestellt wird und
in Schritt b. das Substrat mit einer Mehr- oder Vielzahl Graben- und/oder Durchgangsstrukturen (32) versehen wird, die eine Mehr- oder Vielzahl optischer Elemente (30) bilden und
in Schritt c. das Substrat (31) mit den optischen Elementen (30) auf einen Halbleiter-Wafer oder Träger mit einer Mehr- oder Vielzahl von Halbleiterelementen (20) stoff- und/oder formschlüssig verbunden wird, wobei das Substrat (31) laterale Ausdehnungen aufweist, die den Halbleiter-Wafer oder den Träger zumindest teil- oder abschnittsweise überdecken, und wobei je ein optisches Element (30) je einem Halbleiterelement (20) zugeordnet wird und das optisches Element (30) das Halbleiterelement (20) zumindest teil- oder abschnittsweise überdeckt und
wobei anschließend der Halbleiter-Wafer oder der Träger zusammen mit dem Substrat (31) vereinzelt wird, so dass eine Mehr- oder Vielzahl von Beleuchtungs- oder Detektoreinheiten (1) vorliegt.

16. Verfahren nach Anspruch 13, wobei
in Schritt a. ein Substrat (31) bereitgestellt wird und
in Schritt b. das Substrat (31) mit einer Mehr- oder Vielzahl Graben- und/oder Durchgangsstrukturen (32) versehen wird, die eine Mehr- oder Vielzahl optischer Elemente (30) bilden und
vor dem Schritt c. das Substrat (31) mit der Mehr - oder Vielzahl optischer Elemente (30) vereinzelt wird, so dass eine Mehr- oder Vielzahl vereinzelter optischer Elemente (30) vorliegt und
in Schritt c. je einem Halbleiterelement (20) ein optisches Element (30) zugeordnet wird und das optische Element (30) und das Halbleiterelement (20) stoff- und/ oder formschlüssig miteinander verbunden werden, wobei das optische Element (30) das Halbleiterelement (20) zumindest teil- oder abschnittsweise überdeckt, so dass eine Mehr- oder Vielzahl von Beleuchtungs- oder Detektoreinheiten (1) vorliegt.
